# EUROPÄISCHE PATENTANMELDUNG

(11) **EP 3 785 829 A1**
(43) Veröffentlichungstag der Anmeldung: **03.03.2021**
(21) Anmeldenummer: 19194358.8
(22) Anmeldetag: 29.08.2019
(51) Int. Cl.: B22F 7/08, H01L 21/48, H01L 23/373, H01L 23/498, B22F 7/04, H05K 1/03

(54) **SUBSTRATHALBZEUG MIT EINEM SINTERWERKSTOFF**

(71) Anmelder: Siemens Aktiengesellschaft, 80333 München (DE)
(72) Erfinder: Heimann, Matthias, 14469 Potsdam (DE); Müller, Bernd, 16259 Falkenberg (DE); Schellenberg, Christian, 14480 Potsdam (DE); Strogies, Jörg, 14163 Berlin (DE); Wilke, Klaus, 12527 Berlin (DE)

(57) **Zusammenfassung**

Zusammenfassend betrifft die Erfindung ein Substrathalbzeug (100) mit einem Sinterwerkstoff (7) zum Sintern, beispielsweise Schaltungsträger zum Silbersintern. Die Erfindung betrifft weiterhin das effektive Anfertigen von Substrathalbzeugen (100) zum Sintern. Um die Herstellung von gesinterten Halbleitermodulen zu vereinfachen und die Temperaturstabilität zu verbessern wird ein Substrathalbzeug (100) mit einem Sinterwerkstoff (7) vorgeschlagen. Das Substrathalbzeug (100) umfasst ein Substrat (1) mit einer Leitebene (3), wobei die Leitebene (3) zumindest einen Sinterbereich (5) aufweist, wobei ein Depot (70) des Sinterwerkstoffs (7) auf dem Sinterbereich (5) angeordnet ist und der Sinterbereich (5) Strukturen (56, 57) aufweist.

## Beschreibung

Die Erfindung betrifft ein Substrathalbzeug mit einem Sinterwerkstoff zum Sintern, beispielsweise Schaltungsträger zum Silbersintern. Die Erfindung betrifft weiterhin das effektive Anfertigen von Substrathalbzeugen zum Sintern.

Die Nutzung von Sinterpasten ist für bestimmte Anwendungen unerlässlich und stellt in der Elektronikproduktion, insbesondere in der Produktion von Leistungselektronikproduktion eine Herausforderung dar. Die Erfindung kann vorteilhaft für Halbleiter Module, insbesondere für leistungselektronische Halbleitermodule, im Englischen "power modules" zum Einsatz kommen.

Es ist Aufgabe der Erfindung die Herstellung von gesinterten Halbleitermodulen zu vereinfachen und die Temperaturstabilität zu verbessern.

Zur Lösung der Aufgabe wird ein Substrathalbzeug mit einem Sinterwerkstoff bereitgestellt. Das Substrathalbzeug weist dazu ein Substrat mit einer Leitebene auf, wobei die Leitebene zumindest einen Sinterbereich aufweist. Ein Depot des Sinterwerkstoffs ist auf dem Sinterbereich angeordnet und der Sinterbereich weist Strukturen auf. Das Auftragen der Sinterwerkstoffe, z. B. von Sinterpasten, soll nun bereits mit dem Substrathalbzeug durchgeführt werden. Dies vereinfacht die Produktion später erheblich und senkt die Kosten.

Die Herausforderungen an das Aufbringen der Sinterwerkstoffe, z. B. an Sinterpastendruck, können durch gezielte Modifikationen des Auftragsverfahrens bzw. der Sinterbereiche verbessert werden. Dazu werden Strukturen in den Schaltungsträger eingebracht. Diese Strukturen dienen dazu die Zuverlässigkeit der Sinterbereiche unter thermischen Beanspruchungen - sowohl während der Produktion als auch während des Betriebs der Module - zu erhöhen. Das Substrat kann dabei bspw. als Keramisches oder als fasergefülltes Kunststoffsubstrat ausgebildet sein. Die Leitebene kann als Oberflächenmetallisierung, z. B. aus Kupfer oder metallisiertem Kupfer, ausgebildet sein und je nach Bedarf und Funktion entsprechend als strukturierte Leitebene ausgebildet sein.

In einer weiteren Ausführungsform weist der Sinterbereich Ausnehmungen als Strukturen auf. Ausnehmungen sind dabei so ausgestaltet, dass die Leitebene in der Ausnehmung vollständig entfernt wird bzw. nicht angebracht wird. Ausnehmungen durchbrechen die Leitebene und sind dabei so angeordnet, dass die Leitebene, zumindest dort wo es gefordert ist, einen zusammenhängenden Leiter bilden kann. Die Ausnehmungen verbessern die Eigenschaften des Sinterbereichs unter Temperatureinfluss. Mechanische Spannungen im Sinterbereich und davon ausgehende Spannungen, die auf das Depot einwirken, werden so verringert. Dies verringert folglich bei einer späteren Weiterverarbeitung Spannungen, die auf den zu montierenden Halbleiter (im Englischen: "Die") auf dem Sinterbereich einwirken. Ausnehmungen können dabei bspw. als Bohrungen oder als Langlöcher ausgestaltet sein. Insbesondere durch den Auftrag bedingte unerwünschte Höhenunterschiede des Sinterdepots können so verringert werden.

In einer weiteren Ausführungsform weist der Sinterbereich Vertiefungen als Strukturen auf. Vertiefungen sind dabei in der Leitebene angeordnet und können halbrund ausgeformt sein. Vertiefungen durchbrechen die Leitebene nicht und dringen nicht bis zum Substrat durch. Die Vertiefungen verbessern die Gleichmäßigkeit des Sinterdepots sowohl beim eigentlichen Auftrag des Sinterwerkstoffs, beispielsweise in Pastenform, als auch später unter thermischer Belastung. Insbesondere durch den Auftrag bedingte unerwünschte Höhenunterschiede des Sinterdepots können so weiter verringert werden. Vertiefungen und Ausnehmungen können dabei vorteilhaft kombiniert werden um den Effekt zu optimieren.

In einer weiteren Ausführungsform sind die Strukturen in einem Randbereich des Sinterbereichs angeordnet. Es hat sich gezeigt, dass der Randbereich des Sinterbereichs eine besonders effektive Anordnung der Elemente ermöglicht. Der Randbereich befindet sich an der Grenze zwischen dem Sinterbereich und der Leitebene und erstreckt sich dabei auf dem Sinterbereich in Richtung von dessen Mitte, bedeckt dabei aber maximal 30% der jeweiligen Ausdehnung.

In einer weiteren Ausführungsform sind die Vertiefungen in einem Randbereich um den Sinterbereich angeordnet. Eine Einrahmung des Sinterbereichs mit Vertiefungen hat sich als besonders vorteilhaft erwiesen, insbesondere wenn die Vertiefungen gleichmäßig den Sinterbereich einrahmen.

In einer weiteren Ausführungsform sind Ausnehmungen in einem Randbereich des Sinterbereichs angeordnet. Insbesondere haben sich Ausnehmungen in Ecken des Sinterbereichs als vorteilhaft erwiesen, wenn der Sinterbereich rechteckförmig oder rechteckähnlich ist. Ausnehmungen im Randbereich, insbesondere in den Ecken, verbessern die mechanischen Spannungen bzgl. des restlichen Substrats weiter.

In einer weiteren Ausführungsform sind die Strukturen so ausgebildet, dass beim Auftragen des Sinterwerkstoffs zumindest ein Teil des Sinterwerkstoffs in die Strukturen fließt. Dies verbessert die Auftragsqualität und letztendlich das Depot weiter.

In einer weiteren Ausführungsform ist das Depot des Sinterwerkstoffs so ausgebildet, dass es am Sinterbereich anhaftet. Dazu kann eine Trocknung und/oder thermische Behandlung des Depots dienen, die nicht zu einem versintern des Depots führt. Es hat sich als besonders vorteilhaft erwiesen, wenn das Depot gleichzeitig Formstabil ist und so einen Transport zum Hersteller der Leistungselektronikmodule unbeschadet übersteht.

In einer weiteren Ausführungsform ist das Substrathalbzeug zum Sintern in einem Temperaturbereich von 200 bis 300°C, vorzugsweise unter erhöhtem Druck, z.B. durch eine Sinterpresse ausgebildet. Die auf den Substrathalbzeugen basierenden Leistungsmodule sind später zur Verwendung in einem Temperaturbereich von 100 bis 220°C, insbesondere 150 bis 220°C ausgebildet. Das Trocknen der Sinterpaste wird bei ca. 100 - 150°C durchgeführt. Im Gegensatz zu Halbzeugen die für Lötverfahren ausgelegt sind, muss das vorliegende Substrathalbzeug also für besonders hohe Temperaturen ausgelegt sein.

Die Aufgabe wird weiterhin durch eine Großkarte (auch Mehrfach-Substrat genannt) gelöst. Da einzelne Substrate in der Regel zu klein sind und um effizient einzeln angefertigt zu werden, hat es sich als vorteilhaft erwiesen gleich mehrere Substrate auf einer Großkarte zur fertigen. Die Großkarte weist dazu mehrere Substrathalbzeuge gemäß einer oder mehrerer der obenstehenden Ausführungsformen auf. Die Großkarte weist zumindest eine Trennstelle auf, die so ausgebildet ist, dass die Substrathalbzeuge vereinzelt werden können. Die Großkarte ist so ausgebildet ist, dass die Substrathalbzeuge insbesondere maschinell und automatisierbar vereinzelt werden können. Die Trennstellen können als Sollbruchstellen im Substrat vorgesehen sein.

In einer weiteren Ausführungsform unterscheiden sich zumindest zwei Substrathalbzeuge auf der Großkarte voneinander. Die vorliegenden Substrathalbzeuge können angepasst werden und mehrere verschiedene Substrathalbzeuge können einfach zu einer Großkarte kombiniert und gefertigt werden. Hier wären beispielsweise unterschiedliche Schalter-Dioden-Kombinationen für unterschiedliche Leistungsanforderungen zu nennen.

In einer weiteren Ausführungsform sind Substrathalbzeuge für zumindest ein Endgerät, beispielsweise einen Umrichter, auf der Großkarte angeordnet. Es hat sich als vorteilhaft erwiesen, wenn alle für ein Endgerät benötigten Halbleitermodule, insbesondere Leistungsmodule auf einer Großkarte angeordnet sind. Die Großkarte mit den Substrathalbzeuge kann dann zur Fertigung des Endgeräts direkt verwendet werden.

Die Aufgabe wird weiterhin gelöst durch ein Verfahren zum Herstellen eines Substrathalbzeugs mit einem Sinterwerkstoff, umfassend die Schritte:
- Bereitstellen eines Substrats mit einer Leitebene und zumindest einem Sinterbereich der Strukturen aufweist,
- Aufbringen des Sinterwerkstoffs auf die Sinterbereiche, sodass der Sinterwerkstoff ein Depot bildet, das an den Sinterbereichen haftet.

Eine weitere Ausführungsform umfasst das Verpacken des Substrathalbzeugs in einer Schutzgasatmosphäre. Dies vereinfachten den Transport und die Lagerung der Substrathalbzeuge. Eine effektive Trennung zwischen dem Herstellen der Substrathalbzeuge und so möglichen deutlich späteren Anordnung der Halbleiter wird so ermöglicht.

Beispielhaft erfolgt nach dem Auftrag einer Sinterpaste als Sinterwerkstoff eine Trocknung und eine Auslieferung mit entsprechender Verpackung zum Kunden.

Im Folgenden wird die Erfindung anhand der in den Figuren dargestellten Ausführungsbeispiele näher beschrieben und erläutert. Es zeigen:
- FIG 1: ein Substrathalbzeug mit Strukturen,
- FIG 2: einen Querschnitt
- FIG 3: einen weiteren Querschnitt,
- FIG 4: ein Substrathalbzeug mit strukturierter Leitebene und
- FIG 5: eine Großkarte mit mehreren Substrathalbzeugen.

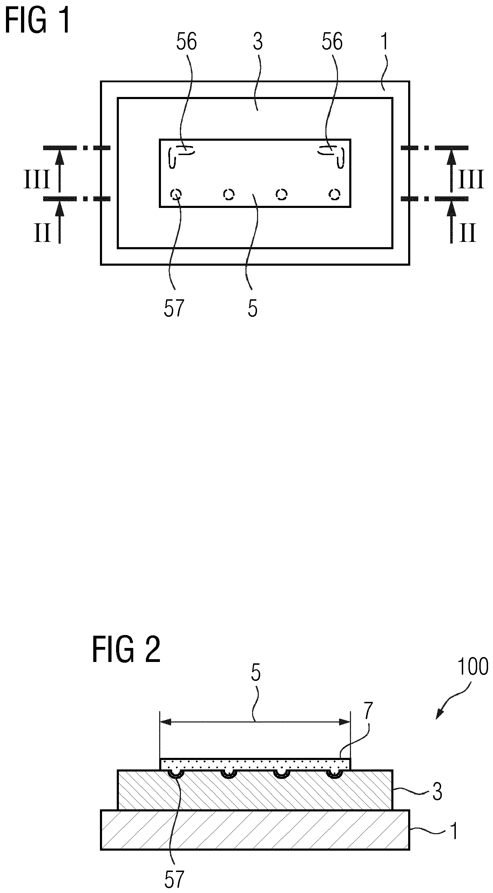

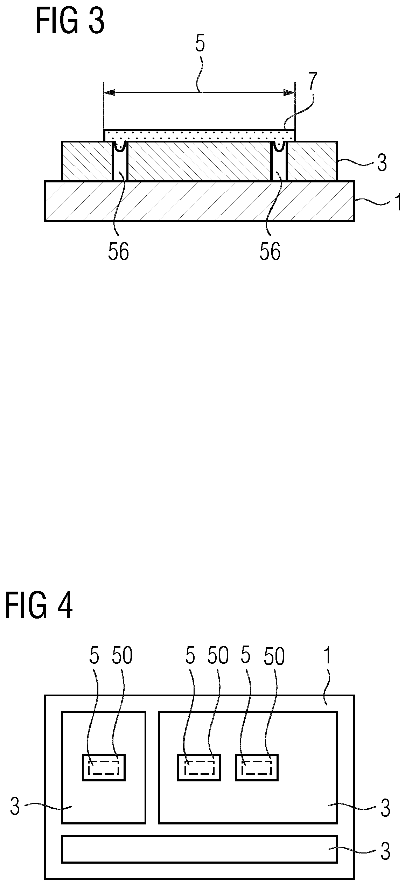

FIG 1 zeigt ein Substrat 1, mit einer Leitebene 3 die einen Sinterbereich 5 aufweist. Im Sinterbereich 5 sind Strukturen 56,57 angeordnet. In diesem Fall beispielhaft dargestellt sind zwei Ausnehmungen 56 und vier Vertiefungen 57. Der Übersichtlichkeit wegen sind die Ausnehmungen 56 und die vier Vertiefungen 57 getrennt voneinander angeordnet. Die Vertiefungen 57 können rundum angeordnet sein, die Ausnehmungen 56 beispielsweise in jeder Ecke und ergänzend mittig bzgl. der Seiten des Sinterbereichs 5. Das Substrat 1 ist hier der Übersichtlichkeit wegen noch ohne Sinterwerkstoff 7 gezeichnet, da sonst die Strukturen 56,57 verdeckt wären. Wird nun auf das vorliegende Substrat 1 ein Sinterwerkstoff 7 aufgebracht so erhält man ein mögliches Substrathalbzeug 100. Die Schnitte II-II und III-III sind in den FIG 2 und 3 jeweils bereits mit aufgetragenem Sinterwerkstoff 7 näher dargestellt.

FIG 2 zeigt einen Querschnitt durch ein Substrathalbzeug 100, wie es in FIG 1 gezeigt wurde, wobei hier bereits Sinterwerkstoff 7 aufgebracht wurde, der ein Depot bildet. Die Vertiefungen 57,4 Stück, sind halbrund ausgeformt und durchdringen nur einen oberen Bereich der Leitebene 3.der Sinterwerkstoff wurde so aufgetragen, dass sich in den Vertiefungen 57 zumindest ein Teil des Sinterwerkstoff anfordert. Es hat sich herausgestellt das beim Aufbringen des Sinterwerkstoff 7 solche Vertiefungen 57 dazu führen, dass die Oberfläche des Sinterwerkstoff 7 von einer höheren Güte ist.

FIG 3 zeigt einen weiteren Schnitt durch das in FIG 1 gezeigte Substrat 1, wobei hier ein Schnitt durch die Ausnehmungen 56 gezeigt ist. Die Ausnehmungen erstrecken sich vollständig durch die Leitebene 3. Es ist zu sehen, dass ein Teil des Sinterwerkstoffs 7 beim Auftragen in die Ausnehmungen 56 gedrückt wurde bzw. in die Ausnehmungen 56 geflossen ist. So ist ca. 1/3 der tiefe der Ausnehmungen 56 mit dem Sinterwerkstoff befüllt. Dies verbessert die Oberflächengüte und verbessert die Anhaftung des Depots des Sinterwerkstoffs 7 an die Leitebene 3.

FIG 4 zeigt ein Beispiel eines Substrats 1 mit einer Leitebene 3, die in diesem Fall als eine dreigeteilte strukturierte Leitebene ausgebildet ist. Es sind weiterhin drei Sinterbereiche 5 vorgesehen. Die Sinterbereiche 5 weisen jeweils einen Randbereich 50 auf, in dem vorteilhaft Strukturen 56, 57 angeordnet werden können. Der Randbereich 50 deckt dabei nicht die vollständige Fläche der Sinterbereiche 5 ab, sondern erstreckt sich wie ein Rahmen auf dem Sinterbereich 5.

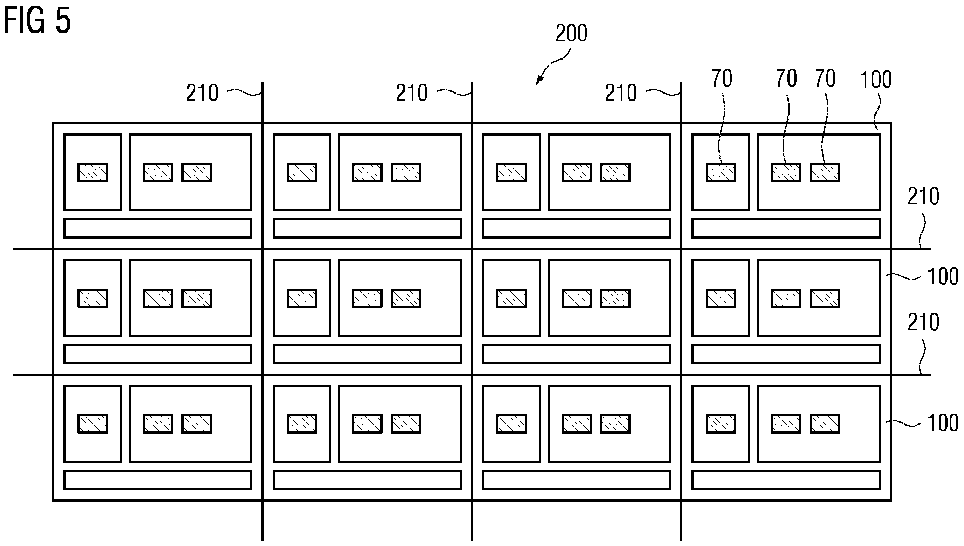

FIG 5 zeigt eine Großkarte 200, die drei Zeilen und vier Spalten aufweist, wobei jede Zelle ein Substrathalbzeug 100 mit einem Depot 70 des Sinterwerkstoffs aufweist. Die Substrathalbzeuge 100 sind durch Trennstellen 210 voneinander getrennt. Die Trennstellen 210 können dabei als Sollbruchstellen, z.B. durch Perforation, ausgestaltet sein. Schneidemarkierungen für Schneidesysteme, wie Laser- oder Flüssigstrahlschneidesysteme, sind ebenso als Trennstellen 210 denkbar. Die zwölf Substrathalbzeuge 100 sind identisch ausgebildet. Insbesondere mit computergestützten, flexiblen Fertigungs- und Designverfahren ist es möglich auf eine einzige Großkarte 200 bereits unterschiedliche Substrathalbzeuge 100 aufzubringen.

Zusammenfassend betrifft die Erfindung ein Substrathalbzeug 100 mit einem Sinterwerkstoff 7 zum Sintern, beispielsweise ein Schaltungsträger zum Silbersintern. Die Erfindung betrifft weiterhin das effektive Anfertigen von Substrathalbzeugen 100 zum Sintern. Um die Herstellung von gesinterten Halbleitermodulen zu vereinfachen und die Temperaturstabilität zu verbessern wird ein Substrathalbzeug 100 mit einem Sinterwerkstoff 7 vorgeschlagen. Das Substrathalbzeug 100 umfasst ein Substrat 1 mit einer Leitebene 3, wobei die Leitebene 3 zumindest einen Sinterbereich 5 aufweist, wobei ein Depot 70 des Sinterwerkstoffs 7 auf dem Sinterbereich 5 angeordnet ist und der Sinterbereich 5 Strukturen 56, 57 aufweist.

**Bezugszeichen:**

| | |
|---|---|
| Substrathalbzeug | 100 |
| Substrat | 1 |
| Leitebene | 3 |
| Sinterbereich | 5 |
| Randbereich | 50 |
| Sinterwerkstoff | 7 |
| Depot des Sinterwerkstoffs | 70 |
| Strukturen | 56, 57 |
| Ausnehmungen | 56 |
| Vertiefungen | 57 |

## Patentansprüche

1. Substrathalbzeug (100) mit einem Sinterwerkstoff (7), umfassend ein Substrat (1) mit einer Leitebene (3), wobei die Leitebene (3) zumindest einen Sinterbereich (5) aufweist, wobei ein Depot (70) des Sinterwerkstoffs (7) auf dem Sinterbereich (5) angeordnet ist und der Sinterbereich (5) Strukturen (56, 57) aufweist.

2. Substrathalbzeug (100) nach Anspruch 1, wobei der Sinterbereich (5) Ausnehmungen (56) als Strukturen (56, 57) aufweist.

3. Substrathalbzeug (100) nach einem der vorhergehenden Ansprüche, wobei der Sinterbereich (5) Vertiefungen (57) als Strukturen (56, 57) aufweist.

4. Substrathalbzeug (100) nach einem der vorhergehenden Ansprüche, wobei die Strukturen (56, 57) in einem Randbereich (50) des Sinterbereichs (5) angeordnet sind.

5. Substrathalbzeug (100) nach einem der vorhergehenden Ansprüche, wobei die Vertiefungen (57) in einem Randbereich um den Sinterbereich (5) angeordnet sind.

6. Substrathalbzeug (100) nach einem der vorhergehenden Ansprüche, wobei Ausnehmungen (56) in einem Randbereich des Sinterbereichs (5) angeordnet sind.

7. Substrathalbzeug (100) nach einem der vorhergehenden Ansprüche, wobei die Strukturen (56, 57) so ausgebildet sind, dass beim Auftragen des Sinterwerkstoffs (7) zumindest ein Teil des Sinterwerkstoffs (7) in die Strukturen (56, 57) fließt.

8. Substrathalbzeug (100) nach einem der vorhergehenden Ansprüche, wobei das Depot (70) des Sinterwerkstoffs (7) so ausgebildet ist, dass es am Sinterbereich (5) anhaftet.

9. Substrathalbzeug (100) nach einem der vorhergehenden Ansprüche, wobei das Substrathalbzeug zum Sintern in einem Temperaturbereich von 200 bis 300°C ausgebildet ist.

10. Großkarte (200) aufweisend mehrere Substrathalbzeuge (100) nach einem der Ansprüche 1 bis 9, aufweisend zumindest eine Trennstelle (210), die so ausgebildet ist, dass die Substrathalbzeuge (100) vereinzelt werden können.

11. Großkarte (200) nach Anspruch 10, wobei sich zumindest zwei Substrathalbzeuge (100) auf der Großkarte (200) voneinander unterscheiden.

12. Großkarte (200) nach einem der Ansprüche 10 oder 11, wobei Substrathalbzeuge (100) für zumindest ein Endgerät, insbesondere einen Umrichter, auf der Großkarte angeordnet sind.

13. Verfahren zum Herstellen eines Substrathalbzeugs (100) mit einem Sinterwerkstoff (7), umfassend die Schritte:
- Bereitstellen eines Substrats (1) mit einer Leitebene (3) und zumindest einem Sinterbereich (5), der Strukturen (56, 57) aufweist,
- Aufbringen des Sinterwerkstoffs (7) auf die Sinterbereiche (5), sodass der Sinterwerkstoff (7) ein Depot (70) bildet, das an den Sinterbereichen (5) haftet.

14. Verfahren nach Anspruch 13, umfassend den Schritt: Verpacken des Substrathalbzeugs (100) in einer Schutzgasatmosphäre.
